# EUROPÄISCHE PATENTANMELDUNG

(11) **EP 3 244 448 A1**
(43) Veröffentlichungstag der Anmeldung: **15.11.2017**
(21) Anmeldenummer: 16168776.9
(22) Anmeldetag: 09.05.2016
(51) Int. Cl.: H01L 23/00

(54) **VERBINDER, VERFAHREN ZUR HERSTELLUNG EINES VERBINDERS, LEISTUNGSHALBLEITERMODUL UND VERFAHREN ZUR HERSTELLUNG EINES LEISTUNGSHALBLEITERMODULS**

(71) Anmelder: Heraeus Deutschland GmbH & Co. KG, 63450 Hanau (DE)
(72) Erfinder: Klein, Andreas, 63579 Freigericht (DE); Hinrich, Andreas, 63579 Freigericht (DE)
(74) Vertreter: Kilchert, Jochen

(57) **Zusammenfassung**

Die Erfindung betrifft einen Verbinder (10), aufweisend einen ersten Kontaktierungsabschnitt (21), mindestens einen zweiten Kontaktierungsabschnitt (22) und mindestens einen zwischen dem ersten Kontaktierungsabschnitt (21) und dem zweiten Kontaktierungsabschnitt (22) ausgebildeten Brückenabschnitt (30, 30'). Erfindungsgemäß weist der Verbinder (10) mindestens einen die mechanische Spannung reduzierenden Abschnitt auf.

## Beschreibung

Die Erfindung bezieht sich auf einen Verbinder, aufweisend einen ersten Kontaktierungsabschnitt, mindestens einen zweiten Kontaktierungsabschnitt und mindestens einen zwischen dem ersten Kontaktierungsabschnitt und dem zweiten Kontaktierungsabschnitt ausgebildeten Brückenabschnitt. Die Erfindung bezieht sich ferner auf ein Verfahren zur Herstellung eines erfindungsgemäßen Verbinders. Ferner bezieht sich die Erfindung auf ein Leistungshalbleitermodul, das einen Verbinder, ein Substrat mit mindestens einer strukturierten elektrisch leitenden Beschichtung sowie mindestens einen ersten Leistungshalbleiterchip, der oberseitig eine erste Elektrode aufweist, umfasst. Außerdem bezieht sich die Erfindung auf ein Verfahren zur Herstellung eines erfindungsgemäßen Leistungshalbleitermoduls.

Steigende Anforderungen hinsichtlich der Leistung und Lebensdauer in Zusammenhang mit Leistungselektronik-Modulen erhöhen die Anforderungen an die oberseitige Kontaktierung von Leistungshalbleitern. Bislang werden beispielsweise zur oberseitigen Kontaktierung von Leistungshalbleitern Aluminium-Bonddrahtverbindungen ausgebildet, welche jedoch hinsichtlich der Leistung und Lebensdauer an ihre Grenzen stoßen.

Der Erfindung liegt die Aufgabe zu Grunde, einen weiterentwickelten Verbinder anzugeben, der den thermo-mechanischen Effekten und Belastungen beim Betrieb von Leistungshalbleitern standhält und eine dauerhafte bzw. langlebige Verbindung ermöglicht. Die System-Zuverlässigkeit durch Verwendung eines weiterentwickelten Verbinders soll erhöht werden. Des Weiteren sollen in Zusammenhang mit einem weiterentwickelten Verbinder keine Spannungsspitzen erzeugt werden bzw. vorliegen.

Des Weiteren ist es Aufgabe der vorliegenden Erfindung, ein weiterentwickeltes Verfahren zur Herstellung eines erfindungsgemäßen Verbinders anzugeben. Eine weitere Aufgabe der Erfindung besteht darin, ein weiterentwickeltes Leistungshalbleitermodul sowie ein Verfahren zur Herstellung eines weiterentwickelten Leistungshalbleitermoduls anzugeben.

Erfindungsgemäß wird diese Aufgabe im Hinblick auf einen Verbinder durch die Merkmale des Anspruches 1 gelöst. Im Hinblick auf ein Verfahren zur Herstellung eines Verbinders wird die Aufgabe durch die Merkmale des Anspruches 10 gelöst. Im Hinblick auf ein Leistungshalbleitermodul wird die Aufgabe durch die Merkmale des Anspruches 12 gelöst. Im Hinblick auf ein Verfahren zur Herstellung eines Leistungshalbleitermoduls wird die Aufgabe durch die Merkmale des Anspruches 15 gelöst.

Die Erfindung beruht auf dem Gedanken, einen Verbinder anzugeben, der einen ersten Kontaktierungsabschnitt, mindestens einen zweiten Kontaktierungsabschnitt und mindestens einen zwischen dem ersten Kontaktierungsabschnitt und dem zweiten Kontaktierungsabschnitt ausgebildeten Brückenabschnitt aufweist.

Erfindungsgemäß weist der Verbinder mindestens einen die mechanische Spannung reduzierenden Abschnitt auf. Bei einem derartigen Abschnitt kann es sich um einen mechanischen Schwächungsabschnitt handeln. Mit Hilfe eines die mechanische Spannung reduzierenden Abschnittes können die Spannungen in der bevorzugten Ausdehnungsrichtung reduziert werden. Spannungsspitzen und somit potentielle Delaminations-Keime können demnach im Zusammenhang mit dem Verbinder reduziert werden.

Es ist möglich, dass der erfindungsgemäße Verbinder mehrere Brückenabschnitte aufweist, wobei zwischen jeweils zwei Brückenabschnitten mindestens ein Kontaktierungsabschnitt ausgebildet ist.

Der Verbinder ist vorzugsweise derart ausgebildet, dass
- die Materialdicke eines Brückenabschnitts geringer als die Materialdicke mindestens eines Kontaktierungsabschnitts ist,
   und/oder
- die Querschnittsfläche mindestens eines Kontaktierungsabschnitts maximal 30 % von der Querschnittsfläche eines Brückenabschnitts abweicht, und/oder
- mindestens ein Kontaktierungsabschnitt auf wenigstens einer Seite einen arithmetischen Mittenrauwert Rₐ nach DIN EN ISO 4287:2010 von wenigstens 5 µm aufweist,
   und/oder
- die Materialdicke mindestens eines Kontaktierungsabschnitts vom Brückenabschnitt weggerichtet abnimmt.

Mindestens ein die mechanische Spannung reduzierender Abschnitt kann insbesondere durch eine der vier genannten Ausführungsformen gebildet werden. Es ist möglich, dass ein Verbinder mehrere, die mechanische Spannung reduzierende Abschnitte aufweist, so dass ein Verbinder Kombinationen der vier genannten Ausführungsformen aufweisen kann.

Zunächst ist es möglich, dass die Materialdicke eines Brückenabschnitts geringer als die Materialdicke mindestens eines Kontaktierungsabschnitts ist. Vorzugsweise ist die Materialdicke eines Brückenabschnitts geringer als die Materialdicke eines direkt benachbart angeordneten Kontaktierungsabschnitts. In einer besonders bevorzugten Ausführungsform ist die Materialdicke eines Brückenabschnitts geringer als die beiden benachbarten Kontaktierungsabschnitte.

Es ist möglich, dass die Querschnittsfläche mindestens eines Kontaktierungsabschnitts maximal 30 % von der Querschnittsfläche eines Brückenabschnitts abweicht. Vorzugsweise weicht die Querschnittsfläche mindestens eines Kontaktierungsabschnitts maximal 30 % von der Querschnittsfläche eines benachbarten Brückenabschnitts ab. Außerdem ist es denkbar, dass die Querschnittsfläche eines Brückenabschnitts maximal 30 % von der Querschnittsfläche der benachbarten Kontaktierungsabschnitte abweicht. Vorzugsweise weisen zwei Kontaktierungsabschnitte, zwischen denen mindestens ein Brückenabschnitt ausgebildet ist, übereinstimmende Querschnittsflächen auf.

Als Querschnittsfläche eines Brückenabschnitts bzw. als Querschnittsfläche eines Kontaktierungsabschnitts sind die Flächen zu verstehen, die bei einem Querschnitt durch den Verbinder entstehen, wobei die Schnittachse senkrecht zur Längsachse des Verbinders verläuft. Die Querschnittsfläche wird von der Breite und der Materialdicke des Verbinders gebildet.

Die Materialdicke des Verbinders ist vorzugsweise größer als 100 µm, insbesondere größer als 150 µm, insbesondere größer als 200 µm. Sofern die Materialdicke eines Brückenabschnitts geringer als mindestens ein benachbarter Kontaktierungsabschnitt ist, ist der Brückenabschnitt vorzugweise breiter als der mindestens eine benachbarte Kontaktierungsabschnitt. Hierdurch wird im gesamten Verbinder eine annähernd gleiche Querschnittsfläche gebildet. Die Stromleitfähigkeit ist somit über den gesamten Verbinder vorzugsweise gleich.

Vorzugsweise weisen die beiden Kontaktierungsabschnitte, zwischen denen ein Brückenabschnitt ausgebildet ist, übereinstimmende Breiten auf. Als Breite eines Kontaktierungsabschnitts ist nicht die Materialdicke zu verstehen. Die Breite eines Kontaktierungsabschnitts bezeichnet die Erstreckung, die senkrecht zur Verbindungsachse mit dem Brückenabschnitt verläuft. Die Breite eines Brückenabschnitts kann entsprechend größer sein als die Breite eines und/oder beider benachbarten Kontaktierungsabschnitts/e.

Es ist möglich, dass mindestens ein Kontaktierungsabschnitt auf wenigstens einer Seite einen arithmetischen Mittenrauwert Rₐ nach DIN ISO 4287:2010 von wenigstens 5 µm aufweist. Vorzugsweise ist dieser arithmetische Mittenrauwert auf der Seite bzw dem Oberflächenabschnitt des Kontaktierungsabschnitts ausgebildet, der von einer Bogenform bzw. Wölbungsform des Brückenabschnitts abgewandt ausgebildet ist. Vorzugsweise handelt es sich bei der Seite bzw. dem Oberflächenabschnitt, die/der einen arithmetischen Mittenrauwert Rₐ von wenigstens 5 µm aufweist, um die Kontaktierungsseite des Kontaktierungsabschnitts bzw. um die Unterseite des Kontaktierungsabschnitts.

Des Weiteren ist es möglich, dass die Materialdicke mindestens eines Kontaktierungsabschnitts, vorzugsweise beider Kontaktierungsabschnitte, vom Brückenabschnitt weggerichtet abnimmt. Mit anderen Worten nimmt die Materialdicke eines Kontaktierungsabschnitts, vorzugsweise beider Kontaktierungsabschnitte, mit zunehmendem Abstand vom Brückenabschnitt ab.

Mit anderen Worten nimmt die Materialdicke mindestens eines Kontaktierungsabschnitts, vorzugsweise beider Kontaktierungsabschnitte, zum Brückenabschnitt hin zu. Das heißt, dass mit abnehmendem Abstand zum Brückenabschnitt die Materialdicke mindestens eines Kontaktierungsabschnitts, vorzugsweise beider Kontaktierungsabschnitte, zunimmt.

Der Brückenabschnitt weist vorzugsweise ein anderes Höhenniveau als mindestens ein benachbarter Kontaktierungsabschnitt auf. Mit anderen Worten kann der Brückenabschnitt ein anderes Höhenniveau als der erste Kontaktierungsabschnitt und/oder der zweite Kontaktierungsabschnitt aufweisen. Mindestens ein Brückenabschnitt kann bogenförmig, insbesondere gewölbt, ausgebildet sein. Der Brückenabschnitt kann außerdem stufenartig mit entsprechender Ausbildung von Kanten, ausgebildet sein. Anstelle der Kanten können Radien ausgebildet sein.

Mindestens ein Kontaktierungsabschnitt kann zumindest abschnittsweise an der Unterseite eine strukturierte Oberfläche aufweisen. Eine derartige strukturierte Oberfläche dient zur Ausbildung eines die mechanische Spannung reduzierenden Abschnitts.

Die strukturierte Oberfläche kann aus Rillen und/oder Gräben gebildet sein, wobei vorzugsweise die Rillen und/oder Gräben durch eine zumindest abschnittsweise Strukturierung des Kontaktierungsabschnitts über die gesamte Materialdicke hinweg gebildet ist. Mit anderen Worten kann die strukturierte Oberfläche eines Kontaktierungsabschnitts dadurch erreicht werden, indem der Kontaktierungsabschnitt zumindest abschnittsweise vollständig gewellt ausgebildet ist. In dieser Ausführungsform weist die Oberseite des Kontaktierungsabschnitts ebenfalls eine strukturierte Oberfläche auf. Die Oberseite ist beispielsweise als negative Form der Unterseite ausgebildet.

Die strukturierte Oberfläche kann geriffelt und/oder genoppt und/oder gewellt und/oder gerieft sein.

Außerdem ist es möglich, dass die strukturierte Oberfläche Vertiefungen und/oder Erhöhungen aufweist. Die Vertiefungen und/oder Erhöhungen können beispielsweise mittels eines Ätzverfahrens oder einen Laserverfahrens in die Oberfläche eingebracht werden. Des Weiteren ist es möglich, dass die strukturierte Oberfläche Prägungen aufweist. Mit Hilfe von Prägungen und/oder Vertiefungen und/oder Erhöhungen und/oder durch die Ausbildung einer geriffelten und/oder genoppten und/oder gewellten und/oder gerieften Oberfläche wird eine Strukturierung der Unterseite eines Kontaktierungsabschnitts mit Höhen und Tiefen erzeugt. Aufgrund einer derartigen Strukturierung kann der Verbinder gezielt mechanisch geschwächt werden, so dass ein Verbinder im Betrieb geringer an einer kontaktierten Oberfläche, wie z.B. an einer Chip-Oberseite, zieht.

Aufgrund der Form des Verbinders, insbesondere aufgrund einer strukturierten Oberfläche der Unterseite eines Kontaktierungsabschnittes kann der Verbinder den thermo-mechanischen Effekten und Belastungen beim Betrieb eines Leistungshalbleitermoduls besser standhalten. Es wird eine langlebigere Verbindung zwischen dem Verbinder und einer zu kontaktierenden Fläche des Leistungshalbleitermoduls ermöglicht.

Die Vertiefungen und/oder Erhöhungen und/oder Prägungen können beispielsweise rechteckförmige und/oder quadratische Formen aufweisen. Die Vertiefungen und/oder Erhöhungen und/oder Prägungen können auf der Unterseite untereinander und/oder übereinander angeordnet sein. Auch das versetzte Ausbilden mehrerer Vertiefungen und/oder Erhöhungen und/oder Prägungen zueinander ist möglich.

Die Unterseite mindestens eines Kontaktierungsabschnitts kann zumindest abschnittsweise mittelbar oder unmittelbar mit einem Kontaktierungsmaterial beschichtet sein. Bei dem Kontaktierungsmaterial kann es sich um Lot oder eine Sinterpaste oder einen Leitkleber handeln. Es ist möglich, dass die Unterseite mit einer Lotpaste oder einer Sinterpaste oder einem Sinterkleber beschichtet ist.

Beispielsweise ist die Summe aus der Materialdicke des Kontaktierungsabschnitts und der Schichtdicke des Kontaktierungsmaterials über den beschichteten Abschnitt hinweg konstant. Sofern lediglich die Unterseite eines Kontaktierungsabschnitts eine strukturierte Oberfläche aufweist, ist die genannte Dickensumme konstant gleich.

Es ist mit anderen Worten möglich, dass der Verbinder mit einem Kontaktierungsmaterial vorappliziert ist. Vorzugsweise setzt sich das (vorapplizierte) Kontaktierungsmaterial in Vertiefungen der Unterseite des Kontaktierungsabschnitts ab.

Aufgrund einer strukturierten Oberfläche der Unterseite bzw. der Kontaktierungsseite des Kontaktierungsabschnitts kann die Dicke des Kontaktierungsmaterials über den beschichteten Abschnitt hinweg variieren.

Die Summe aus der Schichtdicke des Kontaktierungsmaterials und der Materialdicke des Kontaktierungsabschnitts ergibt eine gleichmäßige Dicke, so dass eine gleichmäßige Stromtragfähigkeit erzielt wird.

Vorzugsweise weist das Kontaktierungsmaterial Partikel aus Silber und/oder Kupfer und/oder einer Metalllegierung auf.

Der Verbinder kann aus Silber und/oder Kupfer und/oder Aluminium und/oder einer Metalllegierung gebildet sein. Vorzugsweise weist der Verbinder Kupferpartikel auf, wobei die Kupferpartikel eine durchschnittliche Korngröße von mindestens 10 µm, insbesondere von mindestens 15 µm, insbesondere von mindestens 20 µm, insbesondere von mindestens 25 µm, aufweisen.
Des Weiteren ist es möglich, dass der Verbinder Silberpartikel aufweist, wobei die Silberpartikel eine durchschnittliche Korngröße von mindestens 5 µm, insbesondere von mindestens 10 µm, insbesondere von mindestens 15 µm, insbesondere von mindestens 20 µm, aufweisen.

Die durchschnittlichen Korngrößen werden vorzugsweise mit Hilfe eines Linienschnittverfahrens nach DIN EN ISO 643 bestimmt. Sofern mehrere Versionen dieser Norm vorliegen, wird auf die letzte Version dieser Norm vor Hinterlegung der Anmeldung Bezug genommen.

Der Verbinder kann neben Silber und/oder Kupfer und/oder Aluminium weitere Elemente aufweisen. Vorzugsweise weist das Verbindermaterial mindestens 10 ppm, insbesondere mindestens 20 ppm, weitere Elemente auf. Als anderes Element ist ein solches Element zu verstehen, das nicht zur genannten Gruppe Silber und/oder Kupfer und/oder Aluminium zählt.

Der Verbinder weist vorzugsweise eine Materialreinheit von höchstens 99,99 %, insbesondere von höchstens 99,90 %, auf.

Das Kontaktierungsmaterial weist des Weiteren vorzugsweise in einem getrockneten Zustand Reste eines organischen Materials auf. Bei den organischen Materialien handelt es sich vorzugsweise um die nach einer Trocknung verbleibenden anorganischen Materialien von Sinterhilfsmitteln einer Sinterpaste.

Mit Hilfe des erfindungsgemäßen Verbinders ist eine verbesserte oberseitige Kontaktierung von Leistungshalbleitern möglich. Materialien der Leistungshalbleiter umfassen beispielsweise Silizium. Silizium weist einen wesentlich geringeren Ausdehnungskoeffizient als ein Metall auf. Sofern ein Verbinder beispielsweise aus Kupfer besteht, dehnt sich der Verbinder bei einem Ausdehnungskoeffizient von 17 wesentlich stärker aus als das Silizium-Material (Ausdehnungskoeffizient 3). Aufgrund des Ausbildens von die mechanische Spannung reduzierenden Abschnitten wird der Verbinder gezielt derart mechanisch geschwächt, dass er im Betrieb weniger stark an dem kontaktierten Silizium-Element zieht.

Der Verbinder dient vorzugsweise zur Verbindungen von unterschiedlichen, voneinander getrennten Kontaktierungsbereichen. Die Kontaktierungsbereiche sind nicht auf einem gemeinsamen Abschnitt ausgebildet.

Ein weiterer Aspekt der Erfindung betrifft ein Verfahren zur Herstellung eines erfindungsgemäßen Verbinders. Das Verfahren ist durch folgende Verfahrensschritte gekennzeichnet:
a) Bereitstellen eines Bandes oder eines Blechs, insbesondere eines Metallbandes oder eines Metallblechs,
b) Ausformen mehrerer Brückenabschnitte im Band oder im Blech,
c) abschnittsweises Ausbilden von die mechanische Spannung reduzierenden Abschnitten,
d) Vereinzeln des Bandes oder des Blechs derart, dass mindestens ein Verbinder mit mindestens einem Brückenabschnitt, der zwischen mindestens einem ersten Kontaktierungsabschnitt und mindestens einem zweiten Kontaktierungsabschnitt ausgebildet ist, gebildet wird.

Das erfindungsgemäße Verfahren kann beispielsweise in der angegebenen Schrittreihenfolge a) bis d) durchgeführt werden. Des Weiteren ist es möglich, dass die Schritte b) und c) gleichzeitig ausgebildet werden. Mit dem Ausformen mehrerer Brückenabschnitte kann gleichzeitig das Ausbilden von die mechanische Spannung reduzierenden Abschnitten erfolgen. Wiederum ist es möglich, dass der Schritt c) zeitlich vor dem Schritt b) durchgeführt wird.

Zur Durchführung des Schrittes b) kann beispielsweise ein Presswerkzeug zum Einsatz kommen.

Das erfindungsgemäße Verfahren kann außerdem den Schritt e) umfassen. Dieser betrifft ein zumindest abschnittsweises Auftragen von Kontaktierungsmaterial, insbesondere von Lot oder von Sinterpaste oder von Leitkleber, auf die Unterseite/Kontaktierungsseite mindestens eines Kontaktierungsabschnitts. Das Auftragen von Kontaktierungsmaterial kann beispielsweise durch Rakeln, Drucken, Jetten oder Dispensen erfolgen.

Der Schritt e) wird vorzugsweise vor dem Schritt d) durchgeführt. Mit anderen Worten wird das Kontaktierungsmaterial auf mindestens einen Kontaktierungsabschnitt vor dem Vereinzeln des Bandes oder des Blechs aufgetragen. Es ist möglich, dass beim Vereinzeln des Bandes oder des Blechsauch ein mit Kontaktierungsmaterial beschichteter Kontaktierungsabschnitt durchtrennt wird. Nach dem Vereinzeln des Bandes oder des Blechs liegen somit zwei Kontaktierungsabschnitte mit jeweils aufgetragenem Kontaktierungsmaterial vor.

Das Vereinzeln des Bandes oder des Blechs kann mittels Schneiden, beispielsweise Wasserstrahlschneiden oder Laserschneiden erfolgen. Auch ein Vereinzeln durch Stanzen bzw. Abstanzen ist möglich.

Ein weiterer nebengeordneter Aspekt der Erfindung betrifft ein Leistungshalbleitermodul. Das Leistungshalbleitermodul umfasst einen erfindungsgemäßen Verbinder und ein Substrat mit mindestens einer strukturierten elektrisch leitenden Beschichtung, wobei die Struktur der Beschichtung mindestens eine Halbleiterchipanschlussfläche aufweist. Des Weiteren umfasst das erfindungsgemäße Leistungshalbleitermodul einen ersten Leistungshalbleiterchip, der mit der mindestens einen Halbleiterchipanschlussfläche stoffschlüssig verbunden ist, wobei der Leistungshalbleiterchip oberseitig eine erste Elektrode aufweist.

Das erfindungsgemäße Leistungshalbleitermodul umfasst mit anderen Worten einen erfindungsgemäßen Verbinder. Aufgrund der vorteilhaften Ausbildung des Verbinders wird die System-Zuverlässigkeit des erfindungsgemäßen Leistungshalbleitermoduls erhöht.

Das Leistungshalbleitermodul kann des Weiteren
- mindestens eine Kontaktanschlussfläche, die auf der Struktur der Beschichtung des Substrats ausgebildet ist,
   und/oder
- mindestens einen zweiten Leistungshalbleiterchip, der oberseitig eine zweite Elektrode aufweist,
   und/oder
- mindestens einen Pin, der aus einem Gehäuse, das das Substrat und den ersten Leistungshalbleiterchip wenigstens teilweise umgibt, herausführt,
umfassen. Bei mindestens einem Leistungshalbleiterchip kann es sich um einen MOSFET oder um eine Diode oder um ein IGBT handeln.

Bei dem Substrat kann es sich um ein DCB-Substrat (Direct Copper Bonded) oder um eine Leiterplatte (PCB) oder beispielsweise um ein AMB-Substrat (Active Metal Brazed) handeln. Des Weiteren ist es möglich, dass es sich bei dem Substrat um ein Keramiksubstrat handelt.

Der erfindungsgemäße Verbinder kontaktiert mindestens zwei Kontaktierungsbereiche von wenigstens zwei der folgenden Elemente:
- die Kontaktanschlussfläche des Substrats,
- die erste Elektrode des ersten Leistungshalbleiterchips,
- die zweite Elektrode des zweiten Leistungshalbleiterchips,
- den Pin.

Sofern der erfindungsgemäße Verbinder beispielsweise zwei Brückenabschnitte und entsprechend drei Kontaktierungsabschnitte aufweist, kann der Verbinder auch mindestens drei Kontaktierungsbereiche der oben genannten Elemente kontaktieren. Bei entsprechend weiterer Ausbildung des Verbinders mit drei Brückenabschnitten, vier Brückenabschnitten usw. können entsprechend mehr Kontaktierungsbereiche der genannten Elemente kontaktiert werden.

Ein weiterer Aspekt der Erfindung betrifft ein Verfahren zur Herstellung eines erfindungsgemäßen Leistungshalbleitermoduls. Das Verfahren ist durch folgende Verfahrensschritte gekennzeichnet:
f) Herstellen des Substrats mit mindestens einer strukturierten elektrisch leitenden Beschichtung, wobei die Struktur der Beschichtung eine Halbleiterchipanschlussfläche aufweist und der erste Leistungshalbleiterchip, der oberseitig die erste Elektrode aufweist, stoffschlüssig mit der Halbleiterchipanschlussfläche verbunden wird,
g) Herstellen eines erfindungsgemäßen Verbinders,
h) kontaktierendes Verbinden des Verbinders mit mindestens zwei Kontaktierungsbereichen von wenigstens zwei der folgenden Elemente:
   - die Kontaktanschlussfläche des Substrats,
   - die erste Elektrode des ersten Leistungshalbleiterchips,
   - die zweite Elektrode des zweiten Leistungshalbleiterchips,
   - den Pin.

Im Schritt g) können insbesondere die Schritte a) bis e) zur Herstellung eines erfindungsgemäßen Verbinders durchgeführt werden.

Es ist möglich, dass vor dem Schritt h) die Unterseite mindestens eines Kontaktierungsabschnitts des Verbinders zumindest abschnittsweise mittelbar oder unmittelbar mit einem Kontaktierungsmaterial, insbesondere mit einem Lot oder einer Sinterpaste oder einem Leitkleber, beschichtet wird, wobei vorzugsweise das Kontaktierungsmaterial vor dem Schritt h) getrocknet wird.

Das Beschichten eines Kontaktierungsabschnitts mit Kontaktierungsmaterial kann bereits im Zusammenhang mit der Herstellung des Verbinders, also bereits im Zusammenhang mit dem Durchführen der Schritte a) bis e) erfolgen. Sofern das Kontaktierungsmaterial getrocknet wird, kann der Verbinder mit aufgebrachtem Kontaktierungsmaterial einfacher transportiert werden, ohne dass Verschmutzungen aufgrund weicher bzw. flüssiger Kontaktierungsmaterialien auftreten.

In einer weiteren Ausführungsform des erfindungsgemäßen Verfahrens ist es möglich, dass vor dem Schritt h) die mindestens zwei Kontaktierungsbereiche zumindest abschnittsweise mittelbar oder unmittelbar mit einem Kontaktierungsmaterial, insbesondere mit einem Lot oder einer Sinterpaste oder einem Leitkleber, beschichtet werden, wobei vorzugsweise das Kontaktierungsmaterial vor dem Schritt h) getrocknet wird.

Alternativ oder zusätzlich ist das Kontaktierungsmaterial nicht auf den Kontaktierungsabschnitt des Verbinders sondern auf dem Kontaktierungsbereich des Substrates aufgebracht.

Nachfolgend wird die Erfindung anhand von Ausführungsbeispielen unter Bezug auf die beigefügten schematischen Zeichnungen mit weiteren Einzelheiten näher erläutert.

In diesen zeigen:
- Fig. 1a und 1b: Darstellungen in Bezug auf eine erste Ausführungsform eines erfindungsgemäßen Verbinders;
- Fig. 2a und 2b: Darstellungen eines weiteren Ausführungsbeispiels eines erfindungsgemäßen Verbinders;
- Fig. 3a und 3b: Darstellungen einer dritten Ausführungsform eines erfindungsgemäßen Verbinders;
- Fig. 4a und 4b: Darstellungen einer vierten Ausführungsform eines erfindungsgemäßen Verbinders; und
- Fig. 5a und 5b: Darstellungen einer fünften Ausführungsform eines erfindungsgemäßen Verbinders.

Im Folgenden werden für gleiche und gleichwirkende Teile gleiche Bezugsziffern verwendet.

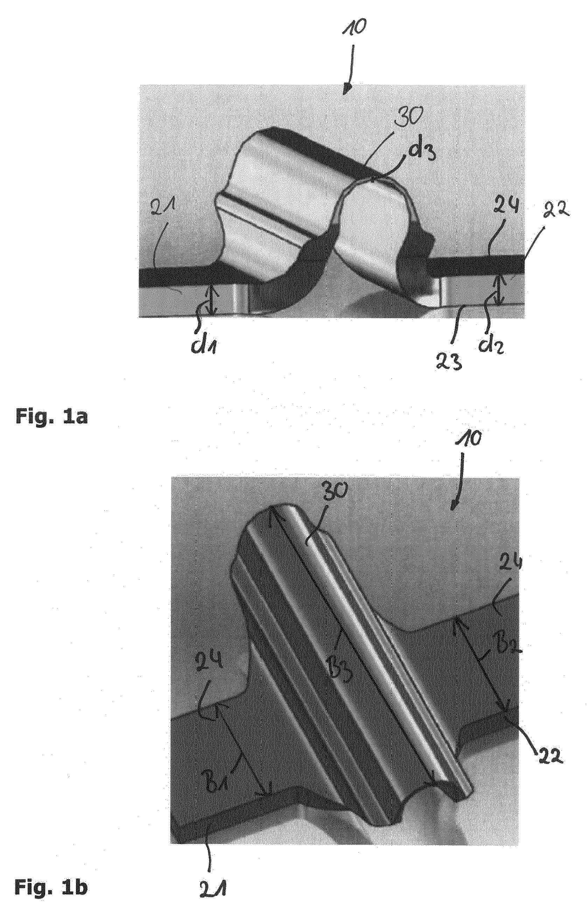

In den Fig. 1a und 1b ist ein Verbinder 10 gemäß einer ersten Ausführungsform dargestellt. Der Verbinder 10 weist einen ersten Kontaktierungsabschnitt 21 und einen zweiten Kontaktierungsabschnitt 22 auf. Zwischen dem ersten Kontaktierungsabschnitt 21 und dem zweiten Kontaktierungsabschnitt 22 ist ein Brückenabschnitt 30 ausgebildet. Der Brückenabschnitt 30 ist gewölbt ausgebildet. Die Unterseiten 23 der Kontaktierungsabschnitte 21 und 22 entsprechen den späteren Kontaktierungsseiten.

Die Dicke d₁ des ersten Kontaktierungsabschnitts 21 entspricht der Dicke d₂ des zweiten Kontaktierungsabschnitts 22. Die Dicken d₁ und d₂ sind über den gesamten ersten Kontaktierungsabschnitt 21 und über den gesamten Kontaktierungsabschnitt 22 hinweg gleich ausgebildet. Im Brückenabschnitt 30 ist die Dicke hingegen am höchsten Punkt der Brückenform am geringsten. Die Dicke d₃ des Brückenabschnittes ist geringer als die Dicke bzw. Materialdicke d₁ und d₂ des ersten Kontaktierungsabschnitts 21 sowie des zweiten Kontaktierungsabschnitts 22. Der Verbinder 30 ist vorzugsweise aus einem Kupfermaterial gebildet.

In Fig. 1b wird der Verbinder 10 der Fig. 1a in einer schrägen Draufsicht dargestellt. Es ist zu erkennen, dass die Breite B₁ des ersten Kontaktierungsabschnitts 21 der Breite B₂ des zweiten Kontaktierungsabschnittes entspricht. Im dargestellten Beispiel ist der Verbinder 10 spiegelsymmetrisch ausgebildet, d.h. dass die Abmaße des ersten Kontaktierungsabschnittes 21 den Abmaßen des zweiten Kontaktierungsabschnittes 22 entsprechen. Die Breite B₃ des Brückenabschnittes 30 ist größer als die Breiten B₁ und B₂ des ersten Kontaktierungsabschnittes 21 sowie des zweiten Kontaktierungsabschnittes 22. Die Querschnittsflächen, die durch die angegebenen Breiten B₁, B₂ und B₃ und den Materialdicken d₁, d₂ und d₃ gebildet werden sind derart ausgebildet, dass die Querschnittsflächen mindestens eines Kontaktierungsabschnitts 21/22 maximal 30 % von der Querschnittsfläche des Brückenabschnittes 30 abweichen.

Die verringerte Dicke d₃ des Brückenabschnittes 30 stellt eine gezielte mechanische Schwächung dar. Aufgrund der geringeren Materialdicke wird ein die mechanische Spannung reduzierender Abschnitt gebildet. Im Betrieb wird der erfindungsgemäße Verbinder 10 weniger stark an einer kontaktierten Oberfläche ziehen. Gleichzeitig ergibt sich aufgrund der konstanten Ausbildung der Querschnittsfläche des ersten Kontaktierungsabschnitts 21 und der Querschnittsfläche des zweiten Kontaktierungsabschnittes 22 sowie der Querschnittsfläche des Brückenabschnittes 30 eine gleichmäßige Stromtragfähigkeit. Da die jeweiligen Flächen keine durchgehenden Schlitze und/oder Löcher und/oder Ausnehmungen aufweisen, werden mechanische Spannungsspitzen und damit potentielle Delaminations-Keime reduziert.

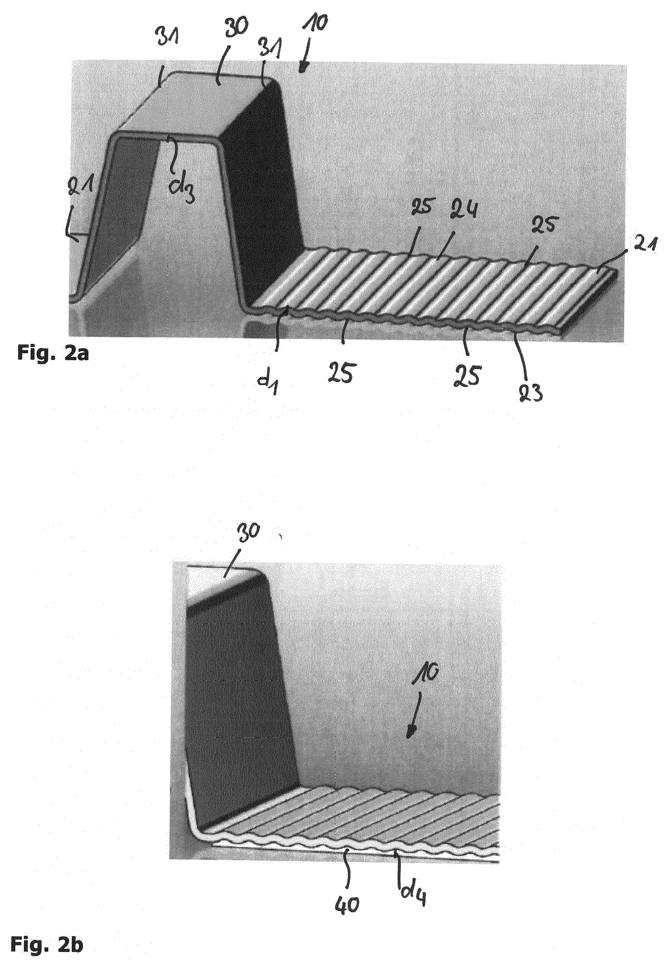

In den Fig. 2a bis 2b ist eine weitere Ausführungsform eines Verbinders 10 dargestellt. Der Brückenabschnitt 30 ist hierbei weniger bogenförmig als vielmehr stufenartig mit entsprechenden Kanten 31 ausgebildet. Dargestellt ist ein erster Kontaktierungsabschnitt 21. Die Dicke d₁ bzw. die Materialdicke des ersten Kontaktierungsabschnittes ist durchgehend gleich und entspricht der Materialdicke d₃ des Brückenabschnittes 30. Auf der Unterseite 23 sowie auf der Oberseite 24 ist eine strukturierte Oberfläche ausgebildet. Die strukturierte Oberfläche wird durch die Ausbildung von Rillen 25 gebildet, wobei die Rillen den Kontaktierungsabschnitt 21 über die gesamte Materialdicke d₁ hinweg strukturieren. Der gesamte erste Kontaktierungsabschnitt 21 weist eine gewellte Form auf.

Der Verbinder 10 kann auf der Unterseite 23 des ersten Kontaktierungsabschnittes 21 zumindest abschnittsweise ein Kontaktierungsmaterial 40 aufweisen (siehe Fig. 2b). Bei dem Kontaktierungsmaterial handelt es sich vorzugsweise um eine Sinterpaste. Es ist auch möglich, dass das Kontaktierungsmaterial ein Lot oder ein Leitkleber ist. Das Kontaktierungsmaterial 40 ist in den Rillen 25 derart aufgetragen, dass dieses die Rillen 25 vollständig füllt. Die strukturierte Oberfläche aus Rillen 25 bildet den, die mechanische Spannung reduzierenden Abschnitt des Verbinders 10. Der Verbinder 10 kann mit einem aufgebrachten Kontaktierungsmaterial 40 als Zwischenprodukt zu einem weiteren Produktionsort geliefert werden, so dass der Verbinder in einem weiteren Verfahrensschritt mit Kontaktierungsbereichen eines Leistungshalbleitermodules kontaktierend verbunden werden können.

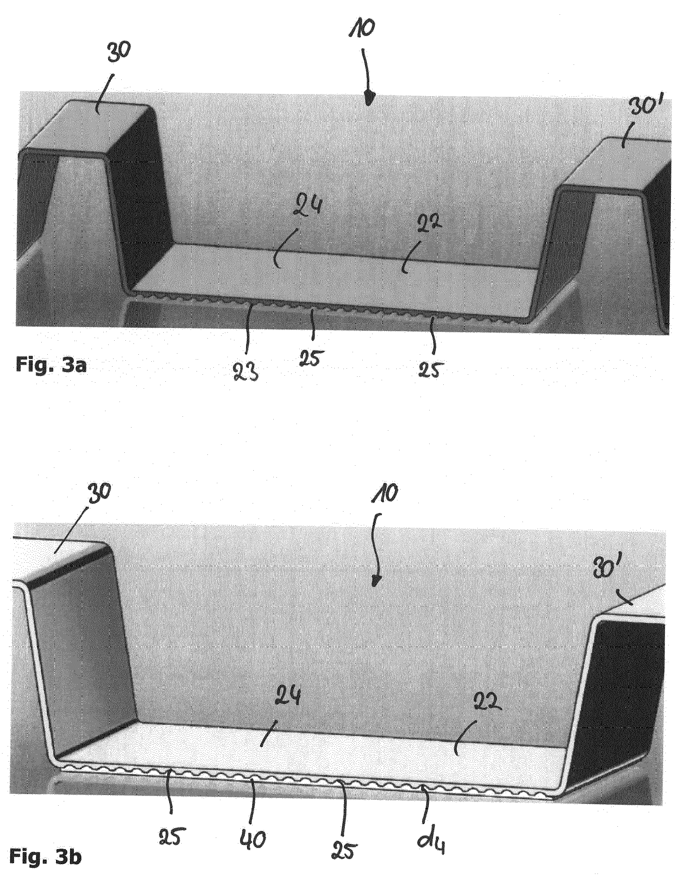

Fig. 3a zeigt eine weitere Ausführungsform eines erfindungsgemäßen Verbinders. Der Verbinders 10 umfasst zwei Brückenabschnitte 30, 30'. Dargestellt ist ein zweiter, die beiden Brückenabschnitte verbindender Kontaktierungsabschnitt 22. Links neben dem ersten Brückenabschnitt 30 ist ein erster Kontaktierungsabschnitt 21 (nicht dargestellt). Rechts neben dem zweiten Brückenabschnitt 30' ist ein weiterer Kontaktierungsabschnitt (nicht dargestellt) ausgebildet. Der Kontaktierungsabschnitt 22 weist auf der Unterseite 23 wiederum eine strukturierte Oberfläche auf, die aus Rillen 25 gebildet ist. Die Oberseite 24 ist im dargestellten Beispiel nicht strukturiert.

In Fig. 3b wird dargestellt, dass das Kontaktierungsmaterial 40 wiederum die Rillen 25 vollständig füllt und über die Rillen 25 bzw. die durch die Rillen 25 gebildete Höhen- und Tiefenstruktur steht.

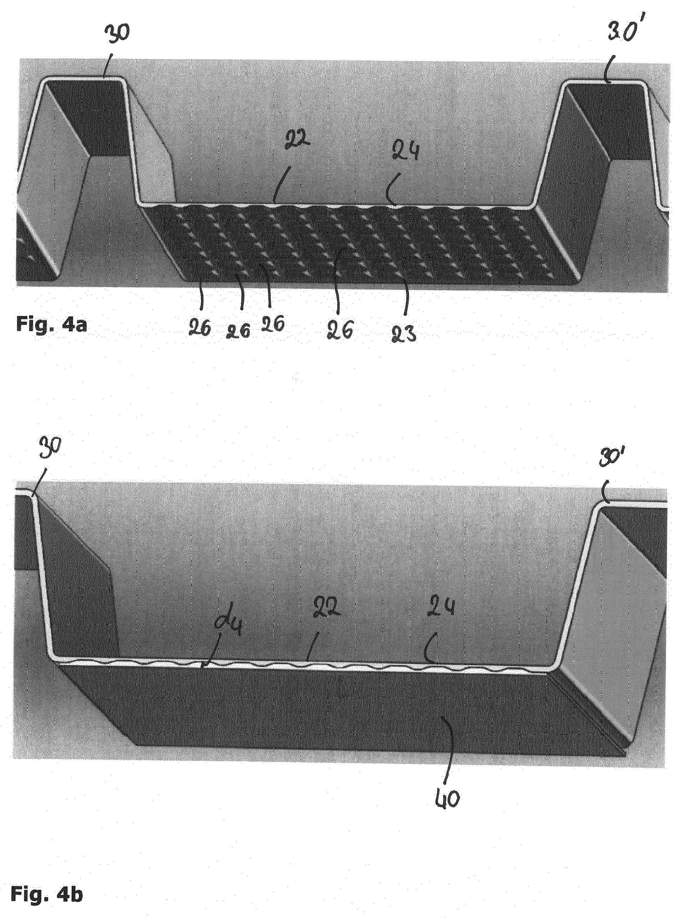

In den Fig. 4a und 4b wird eine weitere Ausführungsform eines Verbinders 10, insbesondere eine strukturierte Oberfläche der Unterseite 23 eines Kontaktierungsabschnittes 22 dargestellt. Auf der Unterseite 23 des zweiten Kontaktierungsabschnittes 22 sind Prägungen bzw. Vertiefungen 26 ausgebildet. Die Prägungen bzw. Vertiefungen weisen Rechteckformen auf. Die Prägungen sind derart eingebracht, dass diese auf der Oberseite 24 nicht sichtbar sind bzw. die Oberseite 24 nicht strukturieren. Die Prägungen 26 sind gleichmäßig nebeneinander und übereinander in Reihe angeordnet.

Die Prägungen 26 werden, wie dies in Fig. 4b dargestellt ist, mit dem Kontaktierungsmaterial 40 aufgefüllt. Insbesondere wird das Kontaktierungsmaterial 40 derart aufgebracht, dass auch die Lücken zwischen den Prägungen 26 mit einem Kontaktierungsmaterial 40 versehen sind. Die Materialdicke d₄ der aufgrund des Kontaktierungsmaterials 40 gebildeten Kontaktierungsschichten sind nicht durchgängig gleich. Die Materialdicke d₄ des Kontaktierungsmaterials 40 variiert.

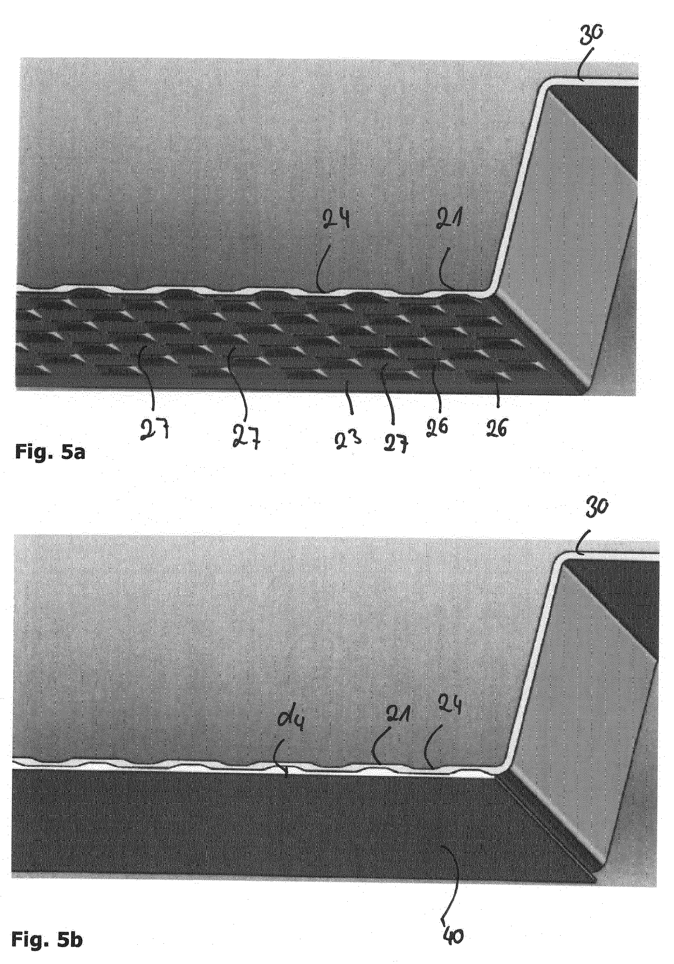

In den Fig. 5a und 5b ist ebenfalls ein Verbinder 10 mit Vertiefungen bzw. Prägungen 26 auf der Unterseite 23 des Kontaktierungsabschnittes 22 dargestellt. Die Vertiefungen bzw. Prägungen 26 sind im in Fig. 5a dargestellten Beispiel versetzt zueinander ausgebildet. Die Prägungen 26 weisen wiederum eine rechteckförmige Struktur auf. In dem dargestellten Beispiel sind die Prägungen 26 derart in den zweiten Kontaktierungsabschnitt 22 eingebracht, dass auch die Oberseite 24 des Kontaktierungsabschnittes strukturiert wird. Insgesamt ergibt sich eine geriffelte Ausführung des Kontaktierungsabschnittes 22.

Wie in Fig. 5b dargestellt ist, setzt sich das Kontaktierungsmaterial 40 sowohl in den durch die Prägungen 26 gebildeten Vertiefungen ab, als auch auf den zwischen den Prägungen 26 ausgebildeten Unterseitenabschnitten 27. Die Materialdicke d₄ des Kontaktierungsmaterials 40 variiert.

### Bezugszeichenliste

- 10: Verbinder
- 21: Erster Kontaktierungsabschnitt
- 22: Zweiter Kontaktierungsabschnitt
- 23: Unterseite
- 24: Oberseite
- 25: Rille
- 26: Prägung
- 27: Unterseitenabschnitt
- 30, 30': Brückenabschnitt
- 31: Kante
- 40: Kontaktierungsmaterial
- d₁: Materialdicke erster Kontaktierungsabschnitt
- d₂: Materialdicke zweiter Kontaktierungsabschnitt
- d₃: Materialdicke Brückenabschnitt
- d₄: Materialdicke Kontaktierungsmaterial
- B₁: Breite erster Kontaktierungsabschnitt
- B₂: Breite zweiter Kontaktierungsabschnitt
- B₃: Breite Brückenabschnitt

## Patentansprüche

1. Verbinder (10), aufweisend einen ersten Kontaktierungsabschnitt (21), mindestens einen zweiten Kontaktierungsabschnitt (22) und mindestens einen zwischen dem ersten Kontaktierungsabschnitt (21) und dem zweiten Kontaktierungsabschnitt (22) ausgebildeten Brückenabschnitt (30, 30'),
**dadurch gekennzeichnet, dass**
der Verbinder (10) mindestens einen die mechanische Spannung reduzierenden Abschnitt aufweist.

2. Verbinder (10) nach Anspruch 1,
**dadurch gekennzeichnet, dass**
- die Materialdicke (d₃) eines Brückenabschnitts (30, 30') geringer als die Materialdicke (d₁, d₂) mindestens eines Kontaktierungsabschnitts (21, 22) ist,
und/oder
- die Querschnittsfläche mindestens eines Kontaktierungsabschnitts (21, 22) maximal 30 % von der Querschnittsfläche eines Brückenabschnitts (30, 30') abweicht,
und/oder
- mindestens ein Kontaktierungsabschnitt (21, 22) auf wenigstens einer Seite einen arithmetischen Mittenrauwert Rₐ nach DIN EN ISO 4287:2010 von wenigstens 5 µm aufweist,
und/oder
- die Materialdicke (d₁, d₂) mindestens eines Kontaktierungsabschnitts (21, 22) vom Brückenabschnitt (30, 30') weggerichtet abnimmt.

3. Verbinder (10) nach Anspruch 1 oder 2,
**dadurch gekennzeichnet, dass**
der Brückenabschnitt (30, 30') ein anderes Höhenniveau als der erste Kontaktierungsabschnitt (21) und/oder der zweite Kontaktierungsabschnitt (22) aufweist, wobei der Brückenabschnitt (30, 30') vorzugsweise bogenförmig, insbesondere gewölbt, oder stufenartig ausgebildet ist.

4. Verbinder (10) nach einem der Ansprüche 1 bis 3,
**dadurch gekennzeichnet, dass**
mindestens ein Kontaktierungsabschnitt (21, 22) zumindest abschnittsweise an der Unterseite (23) eine strukturierte Oberfläche aufweist.

5. Verbinder (10) nach Anspruch 4,
**dadurch gekennzeichnet, dass**
die strukturierte Oberfläche aus Rillen (25) und/oder Gräben gebildet ist, wobei vorzugsweise die Rillen (25) und/oder Gräben durch eine zumindest abschnittsweise Strukturierung des Kontaktierungsabschnitts (21, 22) über die gesamte Materialdicke (d₁, d₂) hinweg gebildet ist.

6. Verbinder (10) nach Anspruch 4 oder 5,
**dadurch gekennzeichnet, dass**
die strukturierte Oberfläche geriffelt und/oder genoppt und/oder gewellt und/oder gerieft ist.

7. Verbinder (10) nach einem der Ansprüche 4 bis 6,
**dadurch gekennzeichnet, dass**
die strukturierte Oberfläche Vertiefungen (26) und/oder Erhöhungen aufweist.

8. Verbinder (10) nach einem der vorhergehenden Ansprüche,
**dadurch gekennzeichnet, dass**
die Unterseite (23) mindestens eines Kontaktierungsabschnitts (21, 22) zumindest abschnittsweise mittelbar oder unmittelbar mit einem Kontaktierungsmaterial (40), insbesondere mit einem Lot oder einer Sinterpaste oder einem Leitkleber, beschichtet ist.

9. Verbinder (10) nach Anspruch 8,
**dadurch gekennzeichnet, dass**
das Kontaktierungsmaterial (40) Partikel aus Silber und/oder Kupfer und/oder einer Metalllegierung aufweist.

10. Verfahren zur Herstellung eines Verbinders (10) nach einem der Ansprüche 1 bis 9,
**gekennzeichnet durch**
die Verfahrensschritte:
a) Bereitstellen eines Bandes oder eines Blechs, insbesondere eines Metallbandes oder eines Metallblechs,
b) Ausformen mehrerer Brückenabschnitte (30, 30') im Band oder im Blech,
c) abschnittsweises Ausbilden von die mechanische Spannung reduzierenden Abschnitten,
d) Vereinzeln des Bandes oder des Blechs derart, dass mindestens ein Verbinder (10) mit mindestens einem Brückenabschnitt (30, 30'), der zwischen mindestens einem ersten Kontaktierungsabschnitt (21) und mindestens einem zweiten Kontaktierungsabschnitt (22) ausgebildet ist, gebildet wird.

11. Verfahren zur Herstellung eines Verbinders (10) nach Anspruch 10, **gekennzeichnet durch**
e) zumindest abschnittsweises Auftragen von Kontaktierungsmaterial (40), insbesondere von Lot oder von Sinterpaste oder von Leitkleber, auf die Unterseite (23) mindestens eines Kontaktierungsabschnitts (21, 22), wobei der Schritt e) vorzugsweise vor dem Schritt d) durchgeführt wird.

12. Leistungshalbleitermodul umfassend
- einen Verbinder (10) nach einem der Ansprüche 1 bis 9 und
- ein Substrat mit mindestens einer strukturierten elektrisch leitenden Beschichtung, wobei die Struktur der Beschichtung mindestens eine Halbleiterchipanschlussfläche aufweist, und
- einen ersten Leistungshalbleiterchip, der mit der Halbleiterchipanschlussfläche stoffschlüssig verbunden ist, wobei der Leistungshalbleiterchip oberseitig eine erste Elektrode aufweist.

13. Leistungshalbleitermodul nach Anspruch 12,
**gekennzeichnet durch**
- mindestens eine Kontaktanschlussfläche, die auf der Struktur der Beschichtung des Substrats ausgebildet ist,
und/oder
- mindestens einen zweiten Leistungshalbleiterchip, der oberseitig eine zweite Elektrode aufweist,
und/oder
- mindestens einen Pin, der aus einem Gehäuse, das das Substrat und den ersten Leistungshalbleiterchip wenigstens teilweise umgibt, herausführt.

14. Leistungshalbleitermodul nach Anspruch 13,
**dadurch gekennzeichnet, dass**
der Verbinder (10) mindestens zwei Kontaktierungsbereiche von wenigstens zwei der folgenden Elemente kontaktiert:
- die Kontaktanschlussfläche des Substrats,
- die erste Elektrode des ersten Leistungshalbleiterchips,
- die zweite Elektrode des zweiten Leistungshalbleiterchips,
- den Pin.

15. Verfahren zur Herstellung eines Leistungshalbleitermoduls nach einem der Ansprüche 12 bis 14,
**gekennzeichnet durch**
die Verfahrensschritte:
f) Herstellen des Substrats mit mindestens einer strukturierten elektrisch leitenden Beschichtung, wobei die Struktur der Beschichtung eine Halbleiterchipanschlussfläche aufweist und der erste Leistungshalbleiterchip, der oberseitig die erste Elektrode aufweist, stoffschlüssig mit der Halbleiterchipanschlussfläche verbunden wird,
g) Herstellen eines Verbinders (10) nach einem der Ansprüche 1 bis 9,
h) kontaktierendes Verbinden des Verbinders (10) mit mindestens zwei Kontaktierungsbereichen von wenigstens zwei der folgenden Elemente:
- die Kontaktanschlussfläche des Substrats,
- die erste Elektrode des ersten Leistungshalbleiterchips,
- die zweite Elektrode des zweiten Leistungshalbleiterchips,
- den Pin.

16. Verfahren nach Anspruch 15,
**dadurch gekennzeichnet, dass**
vor dem Schritt h) die Unterseite (23) mindestens eines Kontaktierungsabschnitts (21, 22) des Verbinders (10) zumindest abschnittsweise mittelbar oder unmittelbar mit einem Kontaktierungsmaterial (40), insbesondere mit einem Lot oder einer Sinterpaste oder einem Leitkleber, beschichtet wird, wobei vorzugsweise das Kontaktierungsmaterial (40) vor dem Schritt h) getrocknet wird.

17. Verfahren nach Anspruch 15 oder 16,
**dadurch gekennzeichnet, dass**
vor dem Schritt h) die mindestens zwei Kontaktierungsbereiche zumindest abschnittsweise mittelbar oder unmittelbar mit einem Kontaktierungsmaterial (40), insbesondere mit einem Lot oder einer Sinterpaste oder einem Leitkleber, beschichtet werden, wobei vorzugsweise das Kontaktierungsmaterial (40) vor dem Schritt h) getrocknet wird.
